Europäisches Patentamt

European Patent Office

Office européen des brevets

(19)

(11) Veröffentlichungsnummer : **0 164 511 B1**

# (12) EUROPÄISCHE PATENTSCHRIFT

(45) Veröffentlichungstag der Patentschrift :
19.07.89

(51) Int. Cl.⁴ : **G 01 R 19/165**

(21) Anmeldenummer : **85103682.2**

(22) Anmeldetag : **27.03.85**

(54) Überwachungsschaltung zur Auswertung der Über- bzw. Unterschreitung vorgegebener Grenzwerte.

(30) Priorität : **05.04.84 DE 3412734**

(43) Veröffentlichungstag der Anmeldung :
**18.12.85 Patentblatt 85/51**

(45) Bekanntmachung des Hinweises auf die Patenterteilung : **19.07.89 Patentblatt 89/29**

(84) Benannte Vertragsstaaten :
**AT BE CH DE FR GB IT LI LU NL SE**

(56) Entgegenhaltungen :
**DE—A— 2 346 933
DE—A— 2 443 274
WESTERN ELECTRIC, Nr. 33, Januar 1974, Seiten 7-8;
W.C. BALCHUNAS: "Audible test set for detecting
opens and mixed gauges in, and incorrect lengths of
cable conductors"
ELEKTOR, Band 3, Nr. 7/8, 1977, Seite 47; R. SLOAN:
"Tri-state voltage comparator"**

(73) Patentinhaber : **i f m electronic gmbh
Teichstrasse 4
D-4300 Essen 1 (DE)**

(72) Erfinder : **Lamarche, Jean-Luc, Dipl.-Ing.
Zeppelinstrasse 1
D-7994 Langenargen (DE)**

(74) Vertreter : **Gesthuysen, Hans Dieter, Dipl.-Ing. et al
Patentanwälte Gesthuysen + von Rohr Huyssenallee
15 Postfach 10 13 33
D-4300 Essen 1 (DE)**

**Beschreibung**

Die Erfindung betrifft eine Schaltungsanordnung zur Auswertung des normalerweise zwischen einem Minimalwert und einem Maximalwert liegenden Impedanzwertes einer eingangsseitig angeschlossenen Indikatorimpedanz, mit einer eingangsseitig vorgesehenen Reihenschaltung aus einem Widerstandsnetzwerk mit mehreren in Reihe geschalteten Hilfswiderständen und aus einem Meßwiderstand und mit einer Überwachungsschaltung, wobei das Widerstandsnetzwerk an der Betriebsspannung oder an einer Hilfsspannung liegt und einen der Unterbrechungsüberwachung dienenden Hilfswiderstand aufweist und wobei die Überwachungsschaltung an das Widerstandsnetzwerk angeschlossen ist, einen Unterbrechungsindikator aufweist und mindestens ein Überwachungssignal abgeben kann.

In zunehmendem Maße werden anstelle von elektrischen, mechanisch betätigten Schaltgeräten, die kontaktbehaftet ausgeführt sind, in elektrischen Meß-, Steuer- und Regelkreisen elektronische, vorzugsweise berührungslos arbeitende Schaltgeräte verwendet. Bei diesen elektronischen Schaltgeräten handelt es sich häufig um solche mit einem von außen beeinflußbaren Anwesenheitsindikator, z. B. einem Oszillator, mit einem dem Anwesenheitsindikator nachgeschalteten Schaltverstärker und mit einem von dem Anwesenheitsindikator über den Schaltverstärker steuerbaren elektronischen Schalter.

Elektronische Schaltgeräte der zuvor angesprochenen Art sind in einer Vielzahl von Ausführungsformen bekannt. Insbesondere sich auch elektronische Schaltgeräte bekannt, die aus zwei zumeist separaten Bauteilen bestehen, nämlich aus einem Indikator und einem Verstärker. Der Indikator stellt für den Verstärker gleichsam einen Indikatorimpedanz dar, d. h. abhängig davon, ob der innerhalb des Indikators verwirklichte Transistoroszillator nicht schwingt (extern bedämpft) oder schwingt bzw. mit einer relativ kleinen Schwingungsamplitude schwingt (extern bedämpft) oder mit einer relativ großen Schwingungsamplitude schwingt, hat der Indikator einen relativ niedrigen Impedanzwert oder einen relativ hohen Impedanzwert; der Impedanzwert liegt normalerweise zwischen einem Minimalwert und einem Maximalwert.

Zuvor ist in Verbindung mit einem Schaltgerät, das aus einem Indikator und einem Verstärker besteht, die Auswertung des normalerweise zwischen einem Minimalwert und einem Maximalwert liegenden Impedanzwertes einer Indikatorimpedanz angesprochen worden. Darüber hinaus gibt es eine Vielzahl von anderen Anwendungsfällen, in denen es der Auswertung des normalerweise zwischen einem Minimalwert und einem Maximalwert liegenden Impedanzwertes einer Indikatorimpedanz bedarf.

Schaltungsanordnungen zur Auswertung des normalerweise zwischen einem Minimalwert und einem Maximalwert liegenden Impedanzwertes einer eingangsseitig angeschlossenen Indikatorimpedanz können ganz unterschiedlich ausgeführt sein und sind in einer Vielzahl von Ausführungen bekannt (vgl. die Literaturstelle « Western Electric », TECHNICAL DIGEST NO. 33, JANUARY 1974, Seiten 7 und 8, die DE-B-21 43 090, die DE-B-16 16 091, die DE-A-31 27 703 und die DE-B-23 04 211).

Werden normalerweise zwischen einem Minimalwert und einem Maximalwert liegende Impedanzwerte einer Indikatorimpedanz ausgewertet, so kann es vorkommen, daß der Impedanzwert der Indikatorimpedanz über dem normalen Maximalwert liegt, nämlich dann, wenn eine Unterbrechung vorliegt, oder daß der Impedanzwert der Indikatorimpedanz unter dem normalen Minimalwert liegt, nämlich dann, wenn ein Kurzschluß vorliegt. Die bekannte Schaltungsanordnung, von der die Erfindung ausgeht, kann nicht zwischen dem normalen Minimalwert der Indikatorimpedanz und einem unter dem normalen Minimalwert liegenden Impedanzwert unterscheiden; die fehlerhafte Situation Kurzschluß wird also nicht erkannt.

Der Erfindung liegt nun die Aufgabe zugrunde, eine Schaltungsanordnung der in Rede stehenden Art anzugeben, die neben einer Unterbrechungsüberwachung auch eine Kurzschlußüberwachung bezüglich der Indikatorimpedanz ermöglicht.

Die erfindungsgemäße Schaltungsanordnung, bei der die zuvor hergeleitete und aufgezeigte Aufgabe gelöst ist, ist dadurch gekennzeichnet, daß das Widerstandsnetzwerk einen der Kurzschlußüberwachung dienenden Hilfswiderstand und die Überwachungsschaltung einen Kurzschlußindikator aufweisen, daß der Kurzschlußindikator und der Unterbrechungsindikator als Operationsverstärker ausgeführt sind, daß der der Kurzschlußüberwachung dienende Hilfswiderstand einseitig an das Pluspotential der Betriebsspannung bzw. der Hilfsspannung und der der Unterbrechungsüberwachung dienende Hilfswiderstand einseitig an das Minuspotential der Betriebsspannung bzw. der Hilfsspannung angeschlossen sind, daß die nicht-invertierenden Eingänge des Kurzschlußindikators und des Unterbrechungsindikators an das dem Widerstandsnetzwerk ferne Ende des Meßwiderstandes, der invertierende Eingang des Kurzschlußindikators an das dem Pluspotential der Betriebsspannung bzw. der Hilfsspannung ferne Ende des der Kurzschlußüberwachung dienenden Hilfswiderstandes und der invertierende Eingang des Unterbrechungsindikators an das dem Minuspotential der Betriebsspannung bzw. der Hilfsspannung ferne Ende des der Unterbrechungsüberwachung dienenden Hilfswiderstandes angeschlossen sind, daß das Widerstandsnetzwerk — zwischen dem der Kurzschlußüberwachung dienenden Hilfswiderstand und dem der Unterbrechungsüberwachung dienenden Hilfswiderstand — zwei weitere in Reihe geschaltete Hilfswiderstände aufweist, daß die Überwachungsschaltung einen als Operationsverstärker ausgeführten Impedanzindikator aufweist und daß der nicht-invertierende Eingang des Impedanzindikators an die Verbindung der beiden weiteren Hilfswiderstände und der invertierende Eingang des Impedanzindikators an das dem Widerstandsnetzwerk ferne Ende des Meßwiderstandes angeschlossen sind.

Bei der erfindungsgemäßen Schaltungsanordnung stehen an den Hilfswiderständen des Widerstandsnetzwerkes und am Meßwiderstand unterschiedliche Potentiale an, — je nach dem, ob der Impedanzwert der Indikatorimpedanz nicht unter dem normalen Minimalwert und nicht über dem normalen Maximalwert liegt, ob der Impedanzwert der Indikatorimpedanz unter dem normalen Minimalwert liegt oder ob der Impedanzwert der Indikatorimpedanz über dem normalen Maximalwert liegt. Abhängig von den Potentialen an den Hilfswiderständen des Widerstandsnetzwerkes und am Meßwiderstand wird dann ein Überwachungssignal oder werden zwei Überwachungssignale gewonnen. Es kann ein einziges Überwachungssignal gewonnen werden, das dann zum Inhalt hat, daß die fehlerhafte Situation Kurzschluß oder die fehlerhafte Situation Unterbrechung vorliegt. Es können aber auch zwei Überwachungssignale gewonnen werden, nämlich ein Überwachungssignal für die fehlerhafte Situation Kurzschluß und ein anderes Überwachungssignal für die fehlerhafte Situation Unterbrechung.

Im einzelnen gibt es verschiedene Möglichkeiten, die zuvor erläuterte erfindungsgemäße Schaltungsanordnung auszugestalten und weiterzubilden, was im folgenden nur beispielhaft erläutert werden soll.

Zuvor ist bereits ausgeführt worden, daß bei der erfindungsgemäßen Schaltungsanordnung ein Überwachungssignal für die fehlerhafte Situation Kurzschluß und ein anderes Überwachungssignal für die fehlerhafte Situation Unterbrechung gewonnen werden kann, daß aber auch die Möglichkeit besteht, ein einziges Überwachungssignal zu erzeugen, das dann zum Inhalt hat, daß die fehlerhafte Situation Kurzschluß oder die fehlerhafte Situation Unterbrechung vorliegt. Dabei kann die Erzeugung eines Überwachungssignals für die fehlerhaften Situationen Kurzschluß oder Unterbrechung dadurch realisiert sein, daß an den Ausgang des Kurzschlußindikators die Kathode einer Leuchtdiode und an den Ausgang des Unterbrechungsindikators — vorzugsweise über einen Vorwiderstand — die Anode der Leuchtdiode angeschlossen ist.

Vorzugsweise ist im übrigen bei der erfindungsgemäßen Schaltungsanordnung dem Impedanzindikator ein als Operationsverstärker ausgeführter Ausgangsverstärker nachgeschaltet. Im einzelnen kann diese Ausführungsform dadurch gekennzeichnet sein, daß der nicht-invertierende Eingang des Ausgangsverstärkers über einen Ankopplungswiderstand an den Ausgang des Impedanzindikators angeschlossen ist und — über eine Brücke od. dgl. — an ein zwischen dem Pluspotential und dem Minuspotential der Betriebsspannung bzw. der Hilfsspannung liegendes Nullpotential anschließbar ist, daß der invertierende Eingang des Ausgangsverstärkers über einen Ankopplungswiderstand an den Ausgang des Impedanzindikators angeschlossen ist und daß der Ausgang des Ausgangsverstärkers über einen Rückkopplungswiderstand an den invertierenden Eingang des Ausgangsverstärkers angeschlossen ist.

Für die zuletzt beschriebene Ausführungsform der erfindungsgemäßen Schaltungsanordnung gilt zunächst, daß dann, wenn keine fehlerhafte Situation, also weder ein Kurzschluß noch eine Unterbrechung, vorliegt, der Impedanzindikator als Schmitt-Trigger arbeitet und mit seinem Ausgang den Ausgangsverstärker steuert. Ist der nicht-invertierende Eingang des Ausgangsverstärkers nicht an ein zwischen dem Pluspotential und dem Minuspotential der Betriebsspannung bzw. der Hilfsspannung liegendes Nullpotential angeschlossen, so folgt der Ausgang des Ausgangsverstärkers dem Ausgang des Impedanzindikators ; der Ausgangsverstärker wirkt also nur als Impedanzwandler. Ist jedoch der nicht-invertierende Eingang des Ausgangsverstärkers an ein zwischen dem Pluspotential und dem Minuspotential der Betriebsspannung bzw. der Hilfsspannung liegendes Nullpotential angeschlossen, so findet durch den Ausgangsverstärker eine Inversion statt. Handelt es sich bei der erfindungsgemäßen Schaltungsanordnung um ein elektronisches Schaltgerät mit einem Indikator und einem Verstärker, so kann also durch das Schließen einer Brücke, also dadurch, daß der nichtinvertierende Eingang des Ausgangsverstärkers an ein zwischen dem Pluspotential und dem Minuspotential der Betriebsspannung bzw. der Hilfsspannung liegendes Nullpotential angeschlossen wird, aus einem Schaltgerät mit Schließer-Funktion ein solches mit Öffner-Funktion gemacht werden (und umgekehrt).

Bei Schaltungsanordnungen der in Rede stehenden Art ist es erwünscht, daß bei einer fehlerhaften Situation — Kurzschluß oder Unterbrechung — am Ausgang ein bestimmtes Signal ansteht, beispielsweise das Signal « 0 ». Dies ist bei einer weiteren Ausführungsform der erfindungsgemäßen Schaltungsanordnung dadurch sichergestellt, daß der invertierende Eingang des Ausgangsverstärkers über eine in Sperrichtung geschaltete Diode an den Ausgang des Kurzschlußindikators und der nicht-invertierende Eingang des Ausgangsverstärkers über eine in Durchlaßrichtung geschaltete Diode an den Ausgang des Unterbrechungsindikators angeschlossen sind. Hier ist unabhängig davon, ob für den normalen Betrieb eine Schließer-Funktion oder eine Öffner-Funktion realisiert ist, sowohl bei der fehlerhaften Situation Kurzschluß als auch bei der fehlerhaften Situation Unterbrechung am Ausgang des Ausgangsverstärkers und damit am Ausgang der erfindungsgemäßen Schaltungsanordnung das Signal « 0 » gewährleistet.

Wird die erfindungsgemäße Schaltungsanordnung als Schaltgerät mit einem Indikator und einem Verstärker verwendet, so handelt es sich bei der Indikatorimpedanz, deren Impedanzwert ausgewertet werden soll, um eine solche, die erst verzögert, also um eine Verzögerungszeit später als sie an die Betriebsspannung gelegt wird, ihren normalen Impedanzwert erreicht, — weil der in dem Indikator verwirklichte Transistoroszillator Verzögerungszeit zum Schwingungsaufbau benötigt. Folglich muß sichergestellt werden, daß der Verstärker, also die erfindungsgemäße Schaltungsanordnung, erst nach der zuvor erläuterten Verzögerungszeit den Impedanzwert der angeschlossenen Indikatorimpedanz auswertet. Folglich ist eine weitere bevorzugte Ausführungsform der erfindungsgemäßen Schaltungsanordnung nun dadurch gekennzeichnet, daß ein Verzögerungsnetzwerk vorgesehen und der invertierende Eingang des Kurzschlußindikators oder des Unterbrechungsindikators an das Verzögerungsnetzwerk angeschlossen ist. Vorzugsweise besteht dabei das Verzögerungsnetzwerk aus einem an das Pluspotential der Betriebsspannung bzw. der Hilfsspannung angeschlossenen Ladekondensator und einem einerseits an den Ladekondensator und andererseits an das Minuspotential der Betriebsspannung bzw. der Hilfsspannung angeschlossenen Ladewiderstand. Im einzelnen kann dabei der invertierende Eingang des Unterbrechungsindikators über einen Hilfswiderstand an das Pluspotential der Betriebsspannung bzw. der Hilfsspannung, über den der Unterbrechungsüberwachung dienenden Hilfswiderstand an das Minuspotential der Betriebsspannung bzw. der Hilfsspannung und über eine in Sperrichtung geschaltete Diode an die Verbindung von Ladekondensator und Ladewiderstand angeschlossen sein.

Im folgenden wird die Erfindung anhand einer lediglich Ausführungsbeispiele darstellenden Zeichnung nochmals erläutert ; es zeigt

Fig. 1 ein erstes Ausführungsbeispiel einer erfindungsgemäßen Schaltungsanordnung und

Fig. 2 ein zweites Ausführungsbeispiel einer erfindungsgemäßen Schaltungsanordnung.

Die in den Figuren dargestellte Schaltungsanordnung dient der Auswertung des normalerweise zwischen einem Minimalwert und einem Maximalwert liegenden Impedanzwertes einer eingangsseitig angeschlossenen, in den Figuren nicht dargestellten Indikatorimpedanz. Insbesondere kann es sich bei der dargestellten Schaltungsanordnung um den Verstärker eines aus einem Indikator und einem Verstärker bestehenden elektronischen Schaltgerätes handeln. Dann ist die eingangsseitig angeschlossene Indikatorimpedanz der Indikator und stellen der Indikator und der Verstärker insgesamt das elektronische Schaltgerät dar.

Im folgenden wird davon ausgegangen, daß die in den Figuren dargestellte Schaltungsanordnung als Verstärker eines aus einem Indikator und einem Verstärker bestehenden Schaltgerätes verwendet wird. Selbstverständlich ist die Erfindung darauf nicht beschränkt.

Im Ausführungsbeispiel sind die das Widerstandsnetzwerk 1 bildenden Hilfswiderstände 2, 3, 4, 5 in Reihe geschaltet. Dabei weist das Widerstandsnetzwerk 1 zunächst einen der Kurzschlußüberwachung dienenden Hilfswiderstand 2 und einen der Unterbrechungsüberwachung dienenden Hilfswiderstand 3 auf. Im übrigen weist die Überwachungsschaltung 8 zunächst einen Kurzschlußindikator 9 und einen Unterbrechungsindikator 10 auf ; der Kurzschlußindikator 9 und der Unterbrechungsindikator 10 sind als Operationsverstärker ausgeführt. Im einzelnen sind der der Kurzschlußüberwachung dienende Hilfswiderstand 2 einseitig an das Pluspotential 11 der Betriebsspannung und der der Unterbrechungsüberwachung dienende Hilfswiderstand 3 einseitig an das Minuspotential 12 der Betriebsspannung angeschlossen und sind die nicht-invertierenden Eingänge 13, 14 des Kurzschlußindikators 9 und des Unterbrechungsindikators 10 an das dem Widerstandsnetzwerk 1 ferne Ende des Meßwiderstandes 6, der invertierende Eingang 15 des Kurzschlußindikators 9 an das dem Pluspotential 11 der Betriebsspannung ferne Ende der Kurzschlußüberwachung dienenden Hilfswiderstandes 2 und der invertierende Eingang 16 des Unterbrechungsindikators 10 an das Minuspotential 12 der Betriebsspannung ferne Ende des der Unterbrechungsüberwachung dienenden Hilfswiderstandes 3 angeschlossen.

In beiden in den Figuren dargestellten Ausführungsbeispielen ist die Erzeugung eines Überwachungssignals für die fehlerhaften Situationen Kurzschluß oder Unterbrechung dadurch realisiert, daß an dem Ausgang 17 des Kurzschlußindikators 9 die Kathode 18 einer Leuchtdiode 19 und an den Ausgang 20 des Unterbrechungsindikators 10 über einen Vorwiderstand 21 die Anode 22 der Leuchtdiode 19 angeschlossen sind.

Bisher sind nur die Maßnahmen erläutert worden, die bei der erfindungsgemäßen Schaltungsanordnung zur Realisierung der Kurzschluß- und Unterbrechungsüberwachung verwirklicht sind. Die für die Auswertung des normalerweise zwischen einem Minimalwert und einem Maximalwert liegenden Impedanzwertes der eingangsseitig angeschlossenen Indikatorimpedanz notwendigen Maßnahmen sind dadurch realisiert, daß das Widerstandsnetzwerk 1 — zwischen dem der Kurzschlußüberwachung dienenden Hilfswiderstand 2 und dem der Unterbrechungsüberwachung dienenden Hilfswiderstand 3 — zwei weitere in Reihe geschaltete Hilfswiderstände 4, 5 aufweist, daß die Überwachungsschaltung 8 einen als Operationsverstärker ausgeführten Impedanzindikator 22 aufweist und daß der nicht-invertierende Eingang 23 des Impedanzindikators 22 an die Verbindung 24 der beiden weiteren Hilfswiderstände 4, 5 und der invertierende Eingang 25 des Impedanzindikators 22 an das dem Widerstandsnetzwerk 1 ferne Ende des Meßwiderstandes 6 angeschlossen sind. Dabei ist dem Impedanzindikator 22 ein als Operationsverstärker ausgeführter Ausgangsverstärker 26 nachgeschaltet. Im einzelnen ist der nicht-invertierende Eingang 27 des Ausgangsverstärkers 26 über einen Ankopplungswiderstand 28 an den Ausgang 29 des Impedanzindikators 22 angeschlossen und — über eine Brücke 30 — an ein zwischen dem Pluspotential 11 und dem Minuspotential 12 der Betriebsspannung liegendes Nullpotential 31 anschließbar, der invertierende Eingang 32 des Ausgangsverstärkers 26 über einen Ankopplungswiderstand 33 an den Ausgang 29 des Impedanzindikators 22 angeschlossen und der Ausgang 34 des Ausgangsverstärkers 26 über einen Rückkopplungswiderstand 35 an den invertierenden Eingang 32 des Ausgangsverstärkers 26 angeschlossen.

Für die dargestellten und bisher beschriebenen Ausführungsbeispiele der erfindungsgemäßen Schaltungsanordnung gilt zunächst, daß dann, wenn weder ein Kurzschluß noch eine Unterbrechung vorliegt, der Impedanzindikator 22, dessen Ausgang 29 über einen Rückkopplungswiderstand 36 mit seinem nicht-invertierenden Eingang 23 verbunden ist, als Schmitt-Trigger arbeitet und mit seinem Ausgang 29 den Ausgangsverstärker 26 steuert. Ist der nicht-invertierende Eingang 27 des Ausgangsverstärkers 26 nicht an ein zwischen dem Pluspotential 11 und dem Minuspotential 12 der Betriebsspannung liegendes Nullpotential 31 angeschlossen, so folgt der Ausgang 34 des Ausgangsverstärkers 26 dem Ausgang 29 des Impedanzindikators 22; der Ausgangsverstärker 26 wirkt also nur als Impedanzwandler. Ist jedoch der nicht-invertierende Eingang 27 des Ausgangsverstärkers 26 an ein zwischen dem Pluspotential 11 und dem Minuspotential 12 der Betriebsspannung liegendes Nullpotential 31 angeschlossen, so findet durch den Ausgangsverstärker 26 eine Inversion statt; durch das Schließen der Brücke 30 kann aus einem Schaltgerät mit Schließer-Funktion ein solches mit Öffner-Funktion gemacht werden (und umgekehrt).

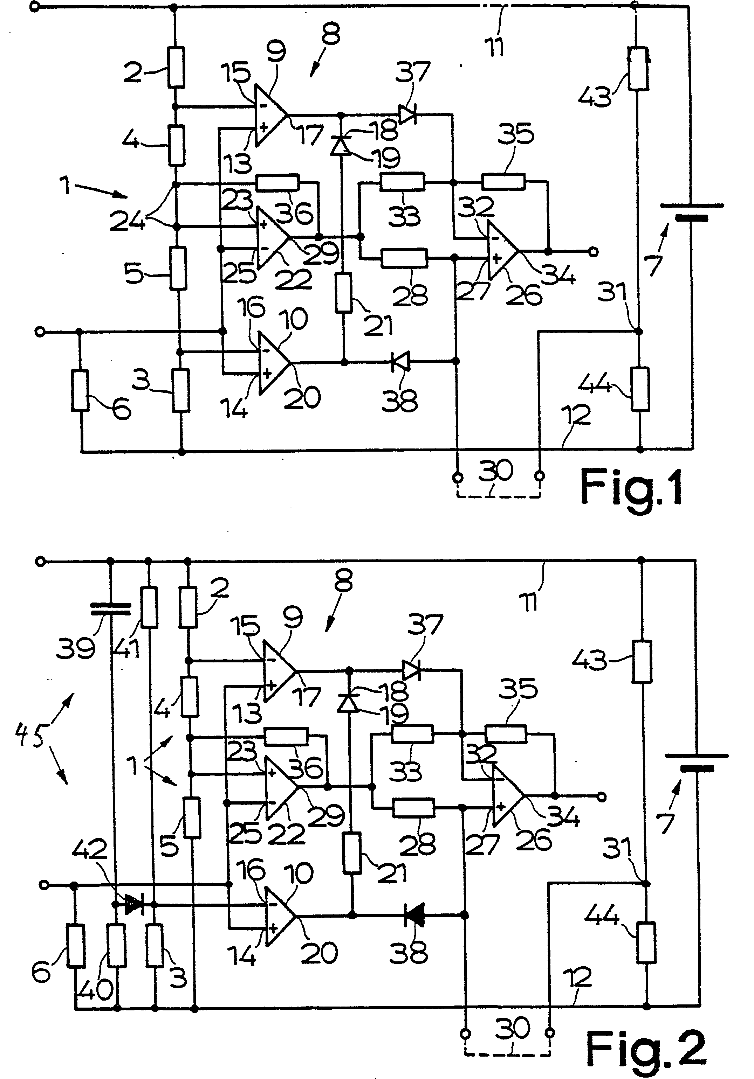

Im übrigen zeigen die Figuren insoweit eine bevorzugte Ausführungsform einer erfindungsgemäßen Schaltungsanordnung, als bei einer fehlerhaften Situation — Kurzschluß oder Unterbrechung — am Ausgang ein bestimmtes Signal ansteht, nämlich das Signal « 0 ». Dies ist dadurch sichergestellt, daß der invertierende Eingang 32 des Ausgangsverstärkers 26 über eine in Sperrichtung geschaltete Diode 37 an den Ausgang 17 des Kurzschlußindikators 9 und der nichtinvertierende Eingang 27 des Ausgangsverstärkers 26 über eine in Durchlaßrichtung geschaltete Diode 38 an den Ausgang 20 des Unterbrechungsindikators 10 angeschlossen sind. Da die erfindungsgemäße Schaltungsanordnung als Verstärker eines aus einem Indikator und einem Verstärker bestehenden elektronischen Schaltgerätes verwendet wird, handelt es sich bei der Indikatorimpedanz, deren Impedanzwert ausgewertet werden soll, um eine solche, die erst verzögert, also um eine Verzögerungszeit später als sie an die Betriebsspannung angelegt wird, ihren normalen Impedanzwert erreicht — weil der in dem Indikator verwirklichte Transistoroszillator die Verzögerungszeit zum Schwingungsaufbau benötigt. Im Ausführungsbeispiel nach Fig. 2 ist nun sichergestellt, daß die erfindungsgemäße Schaltungsanordnung erst nach der zuvor erläuterten Verzögerungszeit den Impedanzwert der angeschlossenen Indikatorimpedanz auswertet. Dazu ist ein Verzögerungsnetzwerk 45 vorgesehen und der invertierende Eingang 16 des Unterbrechungsindikators 10 an das Verzögerungsnetzwerk 38 angeschlossen. Das Verzögerungsnetzwerk 45 besteht aus einem an das Pluspotential 11 der Betriebsspannung angeschlossenen Ladekondensator 39 und einem einerseits an den Ladekondensator 39 und andererseits an das Minuspotential 12 der Betriebsspannung angeschlossenen Ladewiderstand 40. Im einzelnen ist der invertierende Eingang 16 des Unterbrechungsindikators 10 über einen Hilfswiderstand 41 an das Pluspotential 11 der Betriebsspannung, über den der Unterbrechungsüberwachung dienenden Hilfswiderstand 3 an das Minuspotential 12 der Betriebsspannung und über eine in Sperrichtung geschaltete Diode 42 an die Verbindung 43 von Ladekondensator 30 und Ladewiderstand 40 angeschlossen.

Schließlich sei noch darauf hingewiesen, daß in den in den Figuren dargestellten Ausführungsbeispielen der Batterie 7 ein Spannungsteiler aus zwei Spannungsteilerwiderständen 43, 44 parallel geschaltet ist. Mit Hilfe dieses Spannungsteilers wird das Nullpotential 31 gewonnen.

**Patentansprüche**

1. Schaltungsanordnung zur Auswertung des normalerweise zwischen einem Minimalwert und einem Maximalwert liegenden Impedanzwertes einer eingangsseitig angeschlossenen Indikatorimpedanz, mit einer eingangsseitig vorgesehenen Reihenschaltung aus einem Widerstandsnetzwerk (1) mit mehreren in Reihe geschalteten Hilfswiderständen (2-5) und aus einem Meßwiderstand (6) und mit einer Überwachungsschaltung (8), wobei das Widerstandsnetzwerk an der Betriebsspannung (7) oder an einer Hilfsspannung liegt und einen der Unterbrechungsüberwachung dienenden Hilfswiderstand (3) aufweist und wobei die Überwachungsschaltung an das Widerstandsnetzwerk angeschlossen ist, einen Unterbrechungsindikator (33) aufweist und mindestens ein Überwachungssignal abgeben kann, dadurch gekennzeichnet, daß das Widerstandsnetzwerk (1) einen der Kurzschlußüberwachung dienenden Hilfswiderstand (2) und die Überwachungsschaltung (8) einen Kurzschlußindikator (9) aufweisen, daß der Kurzschlußindikator (9) und der Unterbrechungsindikator (10) als Operationsverstärker ausgeführt sind, daß der der Kurzschlußüberwachung dienende Hilfswiderstand (2) einseitig an das Pluspotential (11) der Betriebsspannung bzw. der Hilfsspannung und der Unterbrechungsüberwachung dienende Hilfswiderstand (3) einseitig an das Minuspotential (12) der Betriebsspannung bzw. der Hilfsspannung angeschlossen sind, daß die nicht-invertierenden Eingänge (13, 14) des Kurzschlußindikators (9) und des Unterbrechungsindikators (10) an das dem Widerstandsnetzwerk (1) ferne Ende des Meßwiderstandes (6), der invertierende Eingang (15) des Kurzschlußindikators (9) an das dem Pluspotential (11) der Betriebsspannung bzw. der Hilfsspannung ferne Ende des der Kurzschlußüberwachung dienenden Hilfswiderstandes (2) und der invertierende Eingang (16) des Unterbrechungsindikators (10) an das dem Minuspotential (12) der Betriebsspannung bzw. der Hilfsspannung ferne Ende des der Unterbrechungsüberwachung dienenden Hilfswiderstandes (3) angeschlossen sind, und daß das Widerstandsnetzwerk (1) — zwischen dem der Kurzschlußüberwachung dienenden Hilfswiderstand (2) und dem der Unterbrechungsüberwachung dienenden Hilfswiderstand (3) — zwei weitere in Reihe geschaltete Hilfswiderstände (4, 5) aufweist, daß die Überwachungsschaltung (8) einen als Operationsverstärker ausgeführten Impedanzindikator (22) aufweist und daß der nicht-invertierende Eingang (23) des Impedanzindikators (22) an die Verbindung (24) der beiden weiteren Hilfswiderstände (4, 5) und der invertierende Eingang (25) des Impedanzindikators (22) an das dem Widerstandsnetzwerk (1) ferne Ende des Meßwiderstandes (6) angeschlossen sind.

2. Schaltungsanordnung nach Anspruch 1, dadurch gekennzeichnet, daß an den Ausgang (17) des Kurzschlußindikators (9) die Kathode (18) einer Leuchtdiode (19) und an den Ausgang (20) des Unterbrechungsindikators (10) — vorzugsweise über einen Vorwiderstand (21) — die Anode (22) der Leuchtdiode (19) angeschlossen sind.

3. Schaltungsanordnung nach Anspruch 1 oder 2, dadurch gekennzeichnet, daß dem Impedanzindikator (22) ein als Operationsverstärker ausgeführter Ausgangsverstärker (26) nachgeschaltet ist.

4. Schaltungsanordnung nach Anspruch 3, dadurch gekennzeichnet, daß der nicht-invertierende Eingang (27) des Ausgangsverstärkers (26) über einen Ankopplungswiderstand (28) an dem Ausgang (29) des Impedanzindikators (22) angeschlossen ist und — über eine Brücke (30) — an ein zwischen dem Pluspotential (11) und dem Minuspotential (12) der Betriebsspannung bzw. der Hilfsspannung liegendes Nullpotential (31) anschließbar ist, daß der invertierende Eingang (32) des Ausgangsverstärkers (26) über einen Ankopplungswiderstand (33) an den Ausgang (29) des Impedanzindikators (22) angeschlossen ist und daß der Ausgang (34) des Ausgangsverstärkers (26) über einen Rückkopplungswiderstand (35) an den invertierenden Eingang (32) des Ausgangsverstärkers (26) angeschlossen ist.

5. Schaltungsanordnung nach Anspruch 4, dadurch gekennzeichnet, daß der invertierende Eingang (32) des Ausgangsverstärkers (26) über eine in Sperrrichtung geschaltete Diode (37) an den Ausgang (17) des Kurzschlußindikators (9) und der nicht-invertierende Eingang (27) des Ausgangsverstärkers (26) über eine in Durchlaßrichtung geschaltete Diode (38) an den Ausgang (20) des Unterbrechungsindikators (10) angeschlossen ist.

6. Schaltungsanordnung nach einem der Ansprüche 1 bis 5, dadurch gekennzeichnet, daß ein Verzögerungsnetzwerk (45) vorgesehen und der invertierende Eingang des Kurzschlußindikators oder der invertierende Eingang (16) des Unterbrechungsindikators (10) an das Verzögerungsnetzwerk (45) angeschlossen ist.

7. Schaltungsanordnung nach Anspruch 6, dadurch gekennzeichnet, daß das Verzögerungsnetzwerk (45) aus einem an das Pluspotential (11) der Betriebsspannung bzw. der Hilfsspannung angeschlossenen Ladekondensator (39) und einem einerseits an den Ladekondensator (39) und andererseits an das Minuspotential (12) der Betriebsspannung bzw. der Hilfsspannung angeschlossenen Ladewiderstand (40) besteht.

8. Schaltungsanordnung nach Anspruch 7, dadurch gekennzeichnet, daß der invertierende Eingang (16) des Unterbrechungsindikators (10) über einen Hilfswiderstand (41) an das Pluspotential (11) der Betriebsspannung bzw. der Hilfsspannung, über den der Unterbrechungsüberwachung dienenden Hilfswiderstand (3) an das Minuspotential (12) der Betriebsspannung bzw. der Hilfsspannung und über eine in Sperrrichtung geschaltete Diode (42) an die Verbindung (43) von Ladekondensator (39) und Ladewiderstand (40) angeschlossen ist.

## Claims

1. A circuit arrangement to evaluate the impedance value, normally lying between a minimum value and a maximum value, of an indicator impedance that is connected to the input end, with a series circuit provided at the input end consisting of a resistance network (1) with several auxiliary resistors (2 — 5) connected in series and of a measurement resistor (6) and with a monitor circuit (8), in which the resistance network is connected to the operating voltage (7) or to an auxiliary voltage and possesses an auxiliary resistor (3) serving to monitor open-circuits, and in which the monitor circuit is connected to the resistance network, possesses an open-circuit indicator (33) and can emit at least one monitoring signal, characterized in that the resistance network (1) possesses an auxiliary resistor (2) serving to monitor shortcircuit and the monitor circuit (8) possesses a shortcircuit indicator (9), that the short-circuit indicator (9) and the open-circuit indicator (10) are constructed as operational amplifiers, that one side of the auxiliary resistor (2) that serves to monitor short-circuit is connected to the positive potential (11) of the operating voltage or auxiliary voltage and one side of the auxiliary resistor (3) that serves to monitor open-circuit is connected to the negative potential (12) of the operating voltage or auxiliary voltage, that the non-inverting inputs (13, 14) of the short-circuit indicator (9) and the open-circuit indicator (10) are connected to the end of the measurement resistor (6) that is remote from the resistance network (1), the inverting input (15) of the short-circuit indicator (9) is connected to the end of the auxiliary resistor (2) serving to monitor short-circuit that is remote from the positive potential (11) of the operating voltage or auxiliary voltage and the inverting input (16) of the open-circuit indicator (10) is connected to the end of the auxiliary resistor (3) serving to monitor open-circuit that is remote from the negative potential (12) of the operating voltage or auxiliary voltage, that the resistance network (1) possesses two further auxiliary resistors (4, 5) connected in series — between the auxiliary resistor (2) that serves to monitor short-circuit and the auxiliary resistor (3) that serves to monitor open-circuit — that the monitor circuit (8) possesses an impedance indicator (22) constructed as an operational amplifier and that the non-inverting input (23) of the impedance indicator (22) is connected to the junction (24) between the two further auxiliary resistors (4, 5) and the inverting input (25) of the impedance indicator (22) is connected to the end of the measurement resistor (8) that is remote from the resistance network (1).

2. A circuit arrangement according to Claim characterized in that the cathode (18) of a light-emitting diode (19) is connected to the output (17) of the short-circuit indicator (9), and the anode (22) of the light-emitting diode (19) is connected — preferably via a series resistor (21) — to the output (20) of the open-circuit indicator (10).

3. A circuit arrangement according to Claim 1 or 2, characterized in that an output amplifier (26) constructed as an operational amplifier is connected in series following impedance indicator 22.

4. A circuit arrangement according to Claim 3, characterized in that the non-inverting input (27) of the output amplifier (26) is connected via a coupling resistor (28) to the output (29) of impedance indicator (22) and can be connected — via a bridge (30) — to a zero potential (31) lying between the positive potential (11) and the negative potential (12) of the operating voltage or the auxiliary voltage, that the inverting input (32) of the output amplifier (26) is connected via a coupling resistor (33) to the output (29) of the impedance indicator (22), and that the output (34) of output amplifier (26) is connected via a feedback resistor (35) to the inverting input (32) of the output amplifier (26).

5. A circuit arrangement according to Claim 4, characterized in that the inverting input (32) of the output amplifier (26) is connected to the output (17) of the short-circuit indicator (9) via a diode (37) connected in the blocking direction, and the non-inverting input (27) of the output amplifier (26) is connected to the output (20) of the open-circuit indicator (10) via a diode (38) connected in the conducting direction.

6. A circuit arrangement according to one of Claims 1 to 5, characterized in that a delay network (45) is provided and the inverting input of the short-circuit indicator or the inverting input (16) of the open-circuit indicator (10) is connected to the delay network (45).

7. A circuit arrangement according to Claim 6, characterized in that the delay network (45) consists of a storage capacitor (39) connected to the positive potential (11) of the operating voltage or auxiliary voltage and a storage resistor (40) connected at one end to the storage capacitor (39) and at the other end to the negative potential (12) of the operating voltage or auxiliary voltage.

8. A circuit arrangement according to Claim 7, characterized in that the inverting input (16) of the open-circuit indicator (10) is connected via an auxiliary resistor (41) to the positive potential (11) of the operating voltage or auxiliary voltage, via the auxiliary resistor (3) serving to monitor open-circuit to the negative potential (12) of the operating voltage or auxiliary voltage, and via a diode (42) connected in the blocking direction to the junction between the storage capacitor (39) and the storage resistance (40).

## Revendications

1. Système de commutation pour l'interprétation de la valeur d'impédance, normalement située entre une valeur minimale et une valeur maximale, d'une impédance indicatrice connectée du côté entrée, avec un couplage en série prévu du côté entrée et composé d'un réseau de résistances (1) avec une pluralité de résistances auxiliaires (2 à 5) montées en série et d'une résistance de mesure (6) et avec un circuit de surveillance (8), le réseau de résistances étant relié à la tension de service (7) ou à une tension auxiliaire et comprenant une résistance auxiliaire (3) destinée à contrôler les ruptures, et le circuit de surveillance étant connecté sur le réseau de résistances, présentant un indicateur de rupture (33) et pouvant délivrer au moins un signal de surveillance, caractérisé par le fait que le réseau de résistances (1) comprend une résistance auxiliaire (2) destinée à la surveillance de courts-circuits, et le circuit de surveillance (8), un indicateur de court-circuit (9), que l'indicateur de court-circuit (9) et l'indicateur de rupture (10) sont réalisés sous forme d'amplificateurs opérationnels, que la résistance auxiliaire (2) destinée à la surveillance de courts-circuits est connectée d'un côté au potentiel positif (11) de la tension de service et respectivement de la tension auxiliaire et que la résistance auxiliaire (3) pour la surveillance de ruptures est reliée d'un côté au potentiel négatif (12) de la tension de service et respectivement de la tension auxiliaire, que les entrées positives (13, 14) de l'indicateur de court-circuit (9) et de l'indicateur de rupture (10) sont branchées sur l'extrémité de la résistance de mesure (6) éloignée du réseau de résistances (1), alors que l'entrée négative (15) de l'indicateur de court-circuit (9) est reliée à l'extrémité de la résistance auxiliaire (2) destinée à la surveillance de courts-circuits éloignée du potentiel positif (11) de la tension de service et respectivement de la tension auxiliaire et que l'entrée négative (16) de l'indicateur de rupture (10) est connectée à l'extrémité de la résistance auxiliaire (3) de surveillance de ruptures éloignée du potentiel négatif (12) de la tension de service et respectivement de la tension auxiliaire, que le réseau de résistances (1) comprend — entre la résistance auxiliaire (2) pour la surveillance de courts-circuits et la résistance auxiliaire (3) pour la surveillance de ruptures — deux autres résistances auxiliaires (4, 5) montées en série, que le circuit de surveillance (8) comprend un indicateur d'impédance (22) réalisé sous la forme d'un amplificateur opérationnel, et que l'entrée positive (23) de l'indicateur d'impédance (22) est connectée à la jonction (24) des deux résistances auxiliaires supplémentaires (4, 5), et l'entrée négative (25) de l'indicateur d'impédance (22) à l'extrémité de la résistance de mesure (6) éloignée du réseau de résistances (1).

2. Système de commutation selon la revendication 1, caractérisé par le fait qu'à la sortie (17) de l'indicateur de court-circuit (9) est reliée la cathode (18) d'une diode luminescente (19) et qu'à la sortie (20) de l'indicateur de rupture (10) est reliée, de préférence par l'intermédiaire d'une résistance série (21), l'anode (22) de la diode luminescente (19).

3. Système de commutation selon l'une des revendications 1 ou 2, caractérisé par le fait qu'un amplificateur de sortie (26) réalisé sous forme d'amplificateur opérationnel est monté en aval de l'indicateur d'impédance (22).

4. Système de commutation selon la revendication 3, caractérisé par le fait l'entrée positive (27) de l'amplificateur de sortie (26) est reliée, par l'intermédiaire d'une résistance de couplage (28), à la sortie (29) de l'indicateur d'impédance (22) et peut être connectée — par l'intermédiaire d'un pont (30) — à un potentiel zéro (31) situé entre le potentiel positif (11) et le potentiel négatif (12) de la tension de service et respectivement de la tension auxiliaire, que l'entrée négative (32) de l'amplificateur de sortie (26) est reliée, par l'intermédiaire d'une résistance de couplage (33), à la sortie (29) de l'indicateur d'impédance (22), et que la sortie (34) de l'amplificateur de sortie (26) est connectée, par l'intermédiaire d'une résistance de réinjection (35), à l'entrée négative (32) de l'amplificateur de sortie (26).

5. Système de commutation selon la revendication 4, caractérisé par le fait que l'entrée négative (32) de l'amplificateur de sortie (26) est reliée, par l'intermédiaire d'une diode (37) montée dans le sens d'état bloqué, à la sortie (17) de l'indicateur de court-circuit (9) et que l'entrée positive (27) de l'amplificateur de sortie (26) est reliée, par l'intermédiaire d'une diode (38) montée en sens passant, à la sortie (20) de l'indicateur de rupture (10).

6. Système de commutation selon l'une quelconque des revendications 1 à 5, caractérisé par le fait qu'il comprend un réseau de temporisation (45) et que l'entrée négative (16) de l'indicateur de rupture (10) est reliée au réseau de temporisation (45).

7. Système de commutation selon la revendication 6, caractérisé par le fait que le réseau de temporisation (45) est constitué par un condensateur de charge (39) connecté au potentiel positif (11) de la tension de service et respectivement de la tension auxiliaire et par une résistance de charge (40) reliée d'une part au condensateur de charge (39) et, d'autre part, au potentiel négatif (12) de la tension de service et respectivement de la tension auxiliaire.

8. Système de commutation selon la revendication 7, caractérisé par le fait que l'entrée négative (16) de l'indicateur de rupture (10) est reliée, par l'intermédiaire d'une résistance auxiliaire (41), au potentiel positif (11) de la tension de service et respectivement de la tension auxiliaire, par l'intermédiaire de la résistance auxiliaire (3) servant à la surveillance de ruptures, au potentiel négatif (12) de la tension de service et respectivement de la tension auxiliaire, et par l'intermédiaire d'une diode (42) montée dans le sens d'état bloqué, à la jonction (43) du condensateur de charge (39) et de la résistance de charge (40).

Fig.1

Fig.2